# EUROPÄISCHE PATENTANMELDUNG

(11) **EP 1 795 337 A1**
(43) Veröffentlichungstag der Anmeldung: **13.06.2007**
(21) Anmeldenummer: 05111930.3
(22) Anmeldetag: 09.12.2005
(51) Int. Cl.: B32B 17/10

(54) **Polyvinylacetal-haltige Folie mit verbesserter Gleichmäßigkeit der Längenänderungen über die Breite**

(71) Anmelder: Kuraray Europe GmbH, 65926 Frankfurt am Main (DE)
(72) Erfinder: Karpinski, Andreas, Odenthal 51519 (DE); Wiedemann, Frank Kuraray Specialities Europe Gmbh, Troisdorf 53842 (DE)
(74) Vertreter: Kisters, Michael Marcus

(57) **Zusammenfassung**

Die Erfindung betrifft eine Folie auf Basis von weichmacherhaltigen Polyvinylacetalen mit verbesserter Gleichmäßigkeit der Längenänderungen über die Breite zur Herstellung von Verbundverglasungen sowie deren Verwendung in Verbundverglasung oder Solarmodulen.

## Beschreibung

Die vorliegende Erfindung betrifft eine Folie auf Basis von weichmacherhaltigem Polyvinylacetal mit verbesserter Gleichmäßigkeit der Längenänderungen über die Breite der Folie und mit der Folie hergestellte Verbundverglasungen.

### Technisches Gebiet

Folien auf Basis von weichmacherhaltigen Polyvinylacetalen, in der Regel Polyvinylbutyral (PVB) werden seit langem zur Herstellung von Verbundverglasungen eingesetzt. Hierbei wird die Folie auf eine erste Glasscheibe aufgelegt, mit der zweiten Glasscheibe abgedeckt und anschließend durch Walzen o.ä. zu einem Vorverbund verpresst. Beim Herstellen des Verbundes wird die Folie mit einigen Millimetern Überstand auf das untere Deckglas gelegt. Nach dem Auflegen der Folie wird das obere Deckglas aufgelegt und anschließend der Folienüberstand abgeschnitten. Dieses Trimmen kann manuell oder maschinell durchgeführt werden. Je nach Technik wird die Folie bündig an der Glaskante abgeschnitten oder einige Millimeter definierter Überstand belassen. Um eine gleichmäßige Laminatkante zu erhalten ist es notwendig, dass die Foliekante während des gesamten Vorverbundprozesses parallel zur Glaskante verläuft.

Zwischenschichtfolien für solche Verbundverglasungen werden praktisch ausschließlich durch kontinuierliche Extrusion einer weichmacherhaltigen Polyvinylacetal-Masse hergestellt. Hierbei kommt es zu einem sogenannten "Neck-In" der extrudierten Folie, d.h. einem Zusammenfließen der Masse in Querrichtung im Randbereich, was zu einem vergrößerten Schrumpf an den Rändern der Folie führt. Dieser Schrumpf hat zur Folge, dass die hintere und vordere Querkante der Folie während des Vorverbundprozesses unterschiedlich starken Längenänderungen über die Breite unterliegt, was dazu führt, dass die Querkanten nicht mehr parallel zur Glaskante verlaufen.

Schließt eine solche Folie unmittelbar nach dem Besäumen bündig mit der Glaskante ab, so kommt es während des Verbundprozesses im Randbereich der Verbundverglasung zu hohlen Stellen ohne Folie. Dies führt in der Regel dazu, dass nicht die gesamte Laminatfläche verwertet werden kann, sondern zuerst die Querkanten zurück geschnitten werden müssen. Im schlimmsten Fall kann es an den hohlen Stellen zu Glasbruch im Vorverbundofen kommen.

Steht eine solche Folie unmittelbar nach dem Besäumen über die Glaskante über, so schrumpft diese während des Verbundprozesses im Randbereich bis an die Glaskante, steht aber im Mittelbereich weiter über. In diesem Fall gibt es keine Hohlstellen, führt aber dazu, das die Querkanten gesäubert werden müssen, um das Laminat ohne Verluste zu verwerten. Im schlimmsten Fall kann es zu einer Verschmutzung der Walzen im Vorverbundofen durch überstehende Folie oder zum Zusammenkleben der Laminate im Autoklaven kommen, was zu Glasbruch führen kann.

Auslöser für unzureichende Parallelität der Querkannten sind u.a. unterschiedliche Längsspannungszustände der Folie über deren Breite, welche in den Bereichen mit hoher Spannung zu einer Verkürzung der Folie während des Relaxierprozesses nach dem Auflegen und Abschneiden führt. Insbesondere dann, wenn diese Verkürzung im Randbereich auftritt, führt dieses zu sichelförmigen Querkanten.

Die Auswirkung starker Randspannung sind meist erst bei größeren Scheibenformaten, z.B. ab 2 x 2 m sichtbar. Eine besonders deutliche Beeinträchtigung der Parallelität der Querkannten ist bei den z.Z. in der Glasindustrie maximalen Größe von Verbundverglasungen von ca. 3 x 6 m, zu beobachten.

Es ist bekannt, dass Folien mit gleichmäßigem Dickenprofil, d.h. die äußeren Kanten der Folie haben die gleiche Dicke wie der mittlere Bereich, zu höherer Spannung an den Außenkanten neigen. Zu diesem Problemkreis beschreibt WO 2005/070651 A1 die Herstellung von PVB-Folien mit einer größeren Dicke der Randbereiche der Folie. Hierbei wird als Normdicke der Folie 0,38 mm und im Randbereich der Folie 0,4 mm vorgeschlagen. Diese Publikation spezifiziert den Randbereich der vergrößerten Dicke nicht weiter. Zudem ist die vorgeschlagene vergrößerte Dicke der Folie im Vergleich zur Normdicke von 0.38 mm groß, was zu einem vermehrten Lufteinschluss führen kann.

### Aufgabe

Aufgabe der vorliegenden Erfindung war es daher, Folien mit gleichmäßiger Längenänderung über die Breite bereit zu stellen.

Überraschenderweise wurde gefunden, dass Folien mit einer geringen Randaufbördelung in einem definierten Randbereich eine verbesserte Gleichmäßigkeit der Längenänderungen über die Breite als Folien gleichmäßiger Dicke haben.

### Darstellung der Erfindung

Gegenstand der vorliegenden Erfindung ist daher eine Folie auf Basis von weichmacherhaltigen Polyvinylacetalen mit verbesserter Gleichmäßigkeit der Längenänderungen über die Breite, dadurch gekennzeichnet, dass die Folie bei einer Mindestbreite von 100 cm in den Randbereichen von bis zu 20 cm vom Folienrand eine um 0,1 bis 4,5 % vergrößerte Dicke gegenüber dem Mittelwert der Dicke der übrigen Folienbereiche aufweisen.

Erfindungsgemäße Folien werden bevorzugt durch Extrusion mit einer Mindestbreite von 90 cm, 100 cm, 200 cm, 250 cm oder 300 cm hergestellt. Besonders bevorzugt werden die erfindungsgemäßen Folien in der zur Zeit maximalen Breite, für die Glasverarbeitende Industrie von 321 cm (d.h. 310 cm bis 330 cm) hergestellt.

Die Mindestlänge der Folie ist 200 cm, kann aber in Extrusionsrichtung 10 m, 50 m 100 m, 200 m, 500 m, 1000 m oder 2000 m betragen.

Bevorzugt weisen nur die beiden Randbereiche der erfindungsgemäßen Folien, die in Längs- bzw. Extrusionsrichtung der Folien liegen, eine vergrößerte Dicke auf. Die vergrößerte Dicke der Folien im Randbereich kann auch geringer, wie z.B. 0,9 bis 2,8 % sein. Die Randbereiche, in denen die erfindungsgemäße Folie eine vergrößerte Dicke aufweist, können bis zu 20 cm (gemessen vom Folienrand) breit sein. Es ist möglich, diese Breite auf bis zu 15 cm (gemessen vom Folienrand), insbesondere 5 bis 15 cm oder bis zu 10 cm (gemessen vom Folienrand), insbesondere 10 bis 15 cm zu verringern.

Neben den Randbereichen mit vergrößerter Foliendicke verbessern zusätzlich verminderte Dickenschwankungen der Folie außerhalb der Randbereiche die Gleichmäßigkeit der Längenänderungen über die Breite der erfindungsgemäßen Folien. Bevorzugt weisen erfindungsgemäße Folien daher außerhalb den genannten, verdickten Randbereichen Dickenunterschiede von maximal ± 10 %, bezogen auf den Mittelwert der Dicke der Folie in diesem Abschnitt auf. Je geringer diese Dickenschwankungen ausfallen, desto besser wird in der Regel die Gleichmäßigkeit der Längenänderungen über die Breite der Folie. Bevorzugt weisen erfindungsgemäße Folien daher Dickenunterschiede außerhalb der Randbereiche von maximal ± 5 %, maximal + 3 %, maximal ± 2 % und besonders bevorzugt maximal ± 1,5 % auf.

Die erfindungsgemäßen Folien weisen in den Bereichen außerhalb der Randbereiche die international üblichen Standarddicken von Zwischenschichtfolien für Verbundverglasungen von 0,38, 0,76, 1,14, 1,52 oder 2,28 mm als durchschnittliche Dicke auf.

Polyvinylacetal-Folien werden üblicherweise zum Transport auf zylindrische Kerne aufgewickelt. Folien ohne die erfindungsgemäße Randaufbördelung schrumpfen beim Aufrollen an den Rändern besonders stark, so dass die resultierende Folienrolle nicht zylindrisch ist, sondern an den Rändern eine geringere Dicke als in der Mitte aufweist. Rollen aus erfindungsgemäßer Folie sind dagegen nahezu zylindrisch bzw. weisen sogar eine etwas erhöhte Dicke an den Rollenenden auf.

Die erfindungsgemäßen Folien enthalten bevorzugt Polyvinylacetale wie Polyvinylbutyral, in Mischung mit einem oder mehreren Weichmachern, wie z.B. Dihexyladipat (DHA) und/oder Ethylenglykololigomeren wie 3G7 oder 3G8. Das eingesetzte Polyvinylbutyral kann in unvernetzter oder wie in DE 101 43 109 A1 oder WO 02/40578 A1 beschrieben, in vernetzter Form eingesetzt werden. Besonders bevorzugte unvernetzte Zusammensetzungen sind z.B. in EP 0 185 863, WO 03/097347 oder WO 01/43963 A1 offenbart.

Erfindungsgemäße Folien können in üblicher Weise in Vakuum-, Walzen-, Laminator-, Mikrowellen- oder Autoklavenprozessen zu Verbundglaslaminaten verarbeitet werden (EP 1 235 683 B1 oder EP 1 181 258 B1). Ein weiterer Gegenstand der vorliegenden Erfindung sind daher Verbundglaslaminate, aufgebaut aus mindestens zwei Glasscheiben mit mindestens einer erfindungsgemäßen Folie. Bevorzugt bestehen die Verbundverglasungen aus zwei Glasscheiben mit einer zwischenliegenden, erfindungsgemäßen Folie.

Weiterhin können erfindungsgemäße Folien zur Herstellung von Solarmodulen verwendet werden. Diese bestehen aus einer transparenten Deckschicht und einer Rückseite und mindestens zwei erfindungsgemäßen Folien bestehen, zwischen denen die Solarzellen angeordnet sind. Als Deckschicht kann Glas oder eine transparente witterungsbeständige Folie wie PTFE, Polyvinylidenfluorid oder Polyvinylfluorid (Tedlar, DuPont) eingesetzt werden. Als Rückseite können Glas, PTFE, Polyvinylidenfluorid, Polyvinylfluorid, Metalle oder transparente oder nicht transparente Polymere verwendet werden.

### Beispiele:

Es wurde eine weichmacherhaltige PVB-Mischung der folgenden Zusammensetzung hergestellt und zu einer Folie mit einer Breite von 321 cm und einer durchschnittlichen Dicke von 0,76 mm verarbeitet. Zusammensetzung 75,5 Gew. % Mowital B68 (Restacetatgehalt < 1%, PVOH-Gehalt ca. 29 %), 24,5 Gew.% Dihexyladipat mit den Stabilisierungsmitteln Tinuvin P und BHT. Als Antihaftmittel wurde Kaliumacetat verwendet.

### Vergleichsbeispiel:

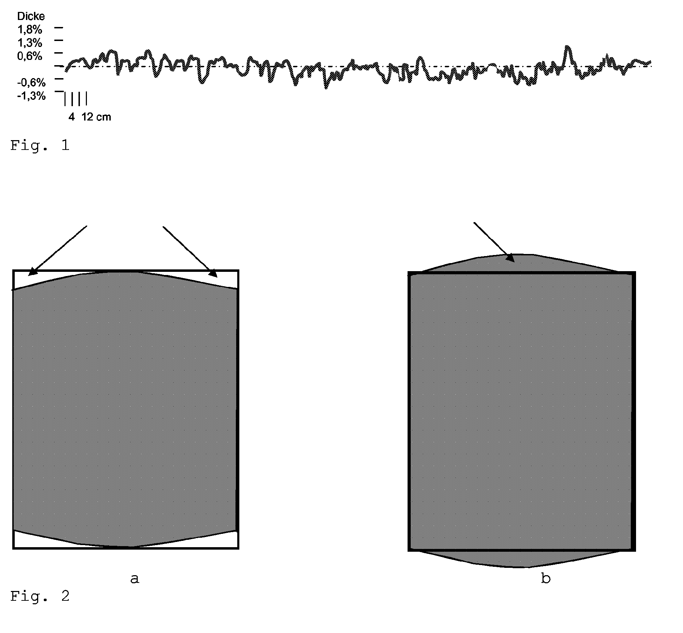

Es wurde eine nahezu planare Folie mit einem Dickenprofil gemäß Fig. 1 hergestellt. Nach der Herstellung eines Vorverbundes mit entsprechend großen Glasscheiben wurden entweder Hohlstellen im Laminat gemäß Fig. 2a oder aber überstehende Folienreste gemäß Fig. 2b beobachtet.

### Beispiel:

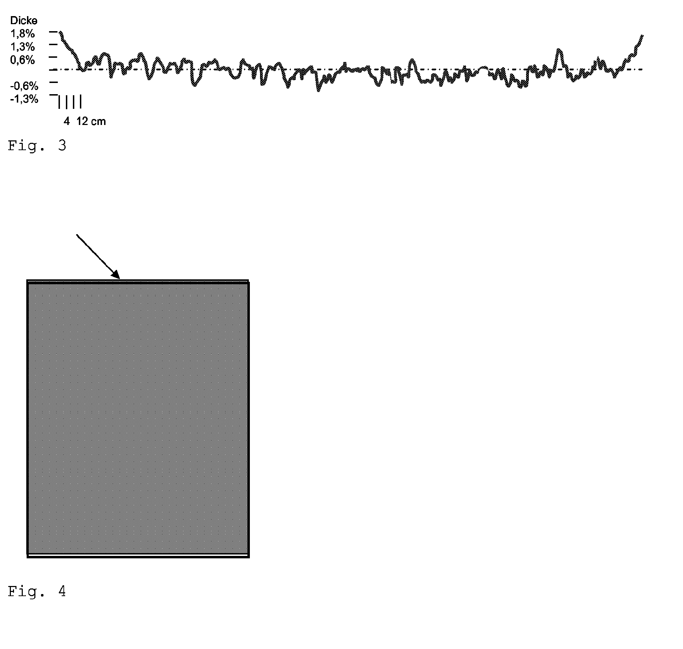

Es wurde eine Folie mit einem Dickenprofil gemäß Fig. 3 hergestellt. Diese Folie wies in den Randbereichen (max. 12 cm vom Rand) eine um ca. 1,8 % vergrößerte Dicke auf. Ein mit dieser Folie hergestelltes Verbundglaslaminat wies parallel zur Glaskante verlaufende Folienkanten gemäß Fig. 4 auf.

Folie und Glas sind deckungsgleich und können ohne weitere Korrekturen oder Besäumungen weiter verarbeitet werden.

## Patentansprüche

1. Folie auf Basis von weichmacherhaltigen Polyvinylacetalen mit verbesserter Gleichmäßigkeit der Längenänderungen über die Breite, **dadurch gekennzeichnet, dass** die Folie bei einer Mindestbreite von 90 cm in den Randbereichen von bis zu 20 cm eine um 0,1 bis 4,5 % vergrößerte Dicke gegenüber dem Mittelwert der Dicke der übrigen Folienbereiche aufweisen.

2. Folie nach Anspruch 1, **dadurch gekennzeichnet, dass** die Ränder der Folie eine um 0,9 bis 2,8 % vergrößerte Dicke aufweisen.

3. Folie nach Anspruch 1 oder 2, **dadurch gekennzeichnet, dass** Randbereiche in Längsrichtung der Folie eine vergrößerte Dicke aufweisen.

4. Folie nach einem der Ansprüche 1 bis 3, **dadurch gekennzeichnet, dass** die Dickenunterschiede der Folie außerhalb der Randbereiche maximal + 10 % zum Mittelwert der Dicke in diesem Abschnitt betragen.

5. Folie nach einem der Ansprüche 1 bis 4, **dadurch gekennzeichnet, dass** die Folie außerhalb der Randbereiche eine durchschnittliche Dicke von 0,38, 0,76, 1,14, 1,52, oder 2,28 mm aufweist.

6. Folie nach einem der Ansprüche 1 bis 5, **dadurch gekennzeichnet, dass** die Folie eine Mindestbreite von 200 cm aufweist.

7. Folie nach einem der Ansprüche 1 bis 5, **dadurch gekennzeichnet, dass** die Folie eine Mindestlänge von 200 cm aufweist.

8. Verbundverglasung, aufgebaut aus mindestens zwei Glasscheiben und mindestens einer Folie gemäß einem der Ansprüche 1 bis 7.

9. Solarmodul, aufgebaut aus einer transparenten Deckschicht und einer Rückseite und mindestens zwei Folien gemäß einem der Ansprüche 1 bis 7, zwischen denen die Solarzellen angeordnet sind.

10. Solarmodul nach Anspruch 9, **dadurch gekennzeichnet, dass** die Deckschicht aus Glas oder einer transparenten, witterungsbeständigen Folie und die Rückseite aus Glas, einem transparenten oder nicht-transparentem Polymer oder einem Metall besteht.
